# EUROPEAN PATENT SPECIFICATION

(11) **EP 4 540 803 B1**
(45) Date of publication and mention of the grant of the patent: **29.07.2026**
(21) Application number: 23735804.9
(22) Date of filing: 16.06.2023
(51) Int. Cl.: G08B 17/00, H10N 10/00, G08B 17/06

(54) **SPACE DETECTOR**
RAUMDETEKTOR
DÉTECTEUR D'ESPACE

(30) Priority: 17.06.2022 FI 20225542
(43) Date of publication of application: 23.04.2025
(73) Proprietor: Happonen, Jarno, 01300 Vantaa (FI)
(72) Inventor: Happonen, Jarno, 01300 Vantaa (FI)
(74) Representative: Kolster Oy Ab
(86) International application number: PCT/FI2023/050361
(87) International publication number: WO 2023/242485

(56) References cited:
- WO-A1-2021/137239
- KR-A- 20150 142 460
- US-A1- 2003 112 145

## Description

### Field of the invention

This invention relates to a space detector which comprises an enclosure, a sensor for detecting a change occurring in a space and an indicator which is arranged to indicate an alarm as a response to a change exceeding a limit value set for the indicator detected by the sensor.

### Description of the prior art

It is known to use electrical detectors based on various detection methods for detecting different harmful events, such as fires, and for indicating the detected events in various spaces. Such detectors are commonly utilized in e.g. residential and storage spaces for preventing personal injuries and material damage, wherein known detectors can quickly provide information on e.g. a fire that has broken for starting measures required by the situation.

However, a problem of these known detector solutions is their need for electric power which involves connecting the devices to either a fixed electric power network or a movable power source arranged into connection with the device. Both of the above solutions are problematic e.g. in relation to such spaces being outside the electrical power network where people's access is limited or even impossible, whereby e.g. charging or replacing the power source of the detector is not practical. In many such locations, e.g. freight traffic sea containers, there is additionally need for quick transmit of detection information for great distances away, e.g. by means of a radio signal. In these locations, the use of non-electrified, e.g. mechanical detectors is also not possible. On the other hand, the use of known power sources, such as batteries, in detectors in relation to, for example, freight traffic sea containers, is problematic due to the risk of ignition caused by them, and the use of such detectors inside a sea container causes changes in the classification of said container. To solve the forementioned issues, it is known from the prior art to use thermoelectrically powered fire detectors, wherein the temperature gradient caused by a fire is used for generating electricity for the detector. Such prior art solutions are known from US2003/112145A1 and WO2021/137239A1. However, said prior art solutions may be further improved so as to enable better reliability and electricity-generating capacity for the detectors.

### Summary of the invention

The purpose of this invention is to solve the above-described problems and introduce a space detector which enables the detection of a change occurring in the space and the indication of the detected change without the need to connect the space detector to an electric power network or a power source.

By composing the space detector such that the space detector comprises, in addition to a sensor and an indicator, also a TEG element arranged between a thermal collector and a thermomass for generating electric power to the space detector by means of a temperature difference between the thermal collector and the thermomass, it is possible to provide the space detector without the need for a separate power source or a connection to the electric power network.

### Brief description of the figures

In the following, the invention will be described in more detail by way of example and with reference to the accompanying figures, in which:
Figure 1 shows an oblique bottom view of the construction of a first embodiment of a space detector,
Figure 2 shows a diagram of a connection of the space detector of Figure 1 to a fire protection system,
Figure 3 shows an oblique bottom view of the construction of a second embodiment of the space detector,
Figure 4 shows an oblique bottom view of the construction of a third embodiment of the space detector, and
Figure 5 shows a diagram of a connection of a fourth embodiment of the space detector to a fire protection system.

### Description of at least one embodiment

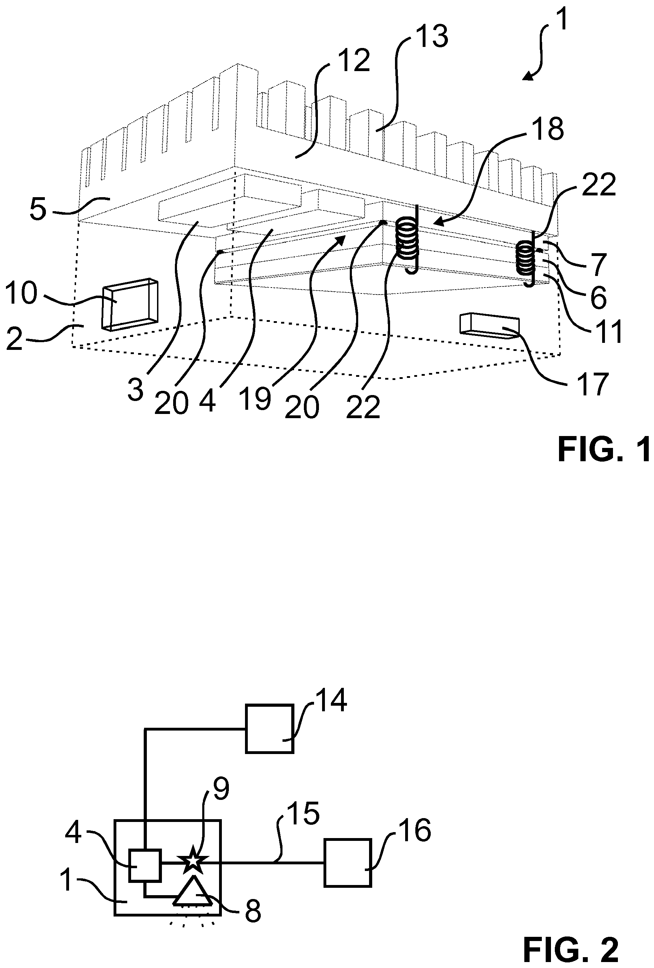

The example of Figure 1 schematically illustrates a simplified construction of a space detector 1 in order to illustrate the operating principle of the space detector 1. In this figure, the space detector is shown such that an enclosure 2 of the space detector has been faded out to clarify the internal construction of the device and, furthermore, several components possibly included within the enclosure 2, either optional by nature, alternative to each other, or conventional by their significance have been left out. It should also be noted that the parts of the space detector are not shown in scale in the figure, but the relative dimensions of the parts, as well as their reciprocal locations, may differ from the example of Figure 1 in each embodiment of the space detector.

In the example of Figure 1, the space detector 1 comprises the above-mentioned enclosure 2, a sensor 3 for detecting a change occurring in the space and an indicator 4 which is arranged to indicate an alarm as a response to a change exceeding a limit value set for the indicator detected by the sensor 3. Said change may be, depending on the use case of the space detector, e.g. an increase in the temperature of the space being monitored due to a fire or some other change observable by sensors or probes comprised in the sensor 3. The limit value set for the indicator 4 may then be chosen to correspond to each event being monitored, whereby the limit value may be e.g. a temperature value clearly higher than the natural temperature in the space. In some use cases of the space detector 1, said limit value may comprise instead of one observed value also a combination of several values of variables measured simultaneously or e.g. a predetermined change value of measured values of one variable over a specific period of time. The indication of the alarm may in some uses of the space detector 1 also occur as a result of falling under said limit value instead of exceeding it. In this context, the alarm refers to any predetermined signal produced by the indicator 4 to indicate a desired event, e.g. a fire.

In addition to said parts, the space detector 1 of the example of Figure 1 comprises a thermal collector 5, which is in connection with a space outside of the enclosure 2, a thermomass 6 arranged within the enclosure 2, and a TEG element 7 arranged between the thermal collector 5 and the thermomass 6. In this context, the TEG element refers to a thermoelectric generator element which may consist of e.g. two or more material layers different from each other. In accordance with the operating principle of a thermoelectric generator, the TEG element 7 generates electric power by means of a temperature difference between its two surfaces, whereby, in the space detector according to the example of Figure 1, one of said surfaces is arranged into connection with the thermal collector 5 and the other surface into connection with the thermomass 6.

In the space detector 1 according to the example of Figure 1, the thermal collector 5 is arranged such of its construction and location that it is well suitable for absorbing thermal energy from the surroundings of the space detector 1. Thereby, when the temperature of the surroundings increases as a result of e.g. a fire or a change in the location of the space detector, the temperature of the thermal collector 5 may be arranged, for example, to follow this increase in temperature as rapidly as possible. In some uses of the space detector, it may be practical that the temperature of the thermal collector 5 reacts to the change in the temperature of the surroundings in some other way, e.g. for providing a controlled delay between the increase in the temperature of the surroundings and the increase in the temperature of the thermal collector 5. By varying the characteristics of the space detector 1 in this way and by arranging the space detector to react to the changes in the temperature of the thermal collector 5 in a desired way, the space detector may also be used for indicating other incidents than fires occurring in the space being monitored, such as for indicating unwanted natural heating.

In order to provide the desired way of reacting of the thermal collector 5 in each case, the thermal collector 5 may be arranged of its construction, e.g. in a way corresponding to Figure 1, to comprise several projections 13 protruding from a bottom plate 12 of the thermal collector whereby, due to these projections 13 being arranged at a distance from each other, the contact area of the thermal collector 5 with the medium surrounding it, such as air, is as large as possible. In other embodiments of the space detector, the thermal collector 5 may also be arranged into contact with a solid medium, such as a wall structure limiting the space being monitored, whereby its shape may also be e.g. planar. When the thermal collector 5 is arranged into contact with the wall structure limiting the space being monitored, and when said wall structure is manufactured of a heat conducting material, the space detector 1 may also be arranged to the outside of the space being monitored. Thereby, the space detector may be used e. g. for detecting fires inside sea freight containers without the necessity to open the container to be monitored for installing the detector. The thermal collector 5 may also be formed of material that conducts heat well, such as of various metal alloys, or its material may be selected e.g. such that the amount of thermal capacity of the thermal collector is as desired. Furthermore, in some embodiments of the space detector, the thermal collector 5 may be formed directly as a part of the construction of the enclosure 2, or it may be formed as a part of the construction of the TEG element 7. Thereby, the construction of the space detector may be further simplified.

In the space detector 1 according to the example of Figure 1, the construction and the material of the thermomass 6 may also be formed in many different ways, depending on e.g. the requirements set by the space being monitored in each use case to the sensitivity of the space detector 1. Thereby, in some use conditions, for example, it may be practical to arrange the thermomass 6 to release heat to its surroundings as effectively as possible for maximizing the temperature difference between the thermomass 6 and the thermal collector 5 whereas, in some other conditions, it may be more preferable to arrange the thermomass 6 such that it, together with the thermal collector 5, provides the remaining of said temperature difference for as long as possible. In this case, the key characteristics of the thermomass 6 are e.g. its thermal conductivity and its contact surface area with the medium surrounding the thermomass 6. In some embodiments of the space detector 1, the thermomass 6 may also be arranged e.g. so great of its thermal capacity, say due to its large mass, that thermal energy conveyed to it e.g. from the TEG element 7, the thermal collector 5 or the surroundings of the thermomass 6 only causes a slight increase in the temperature of the thermomass 6.

In the example of Figure 1, the surface of the thermomass 6 is additionally arranged with an insulation 11 for insulating the thermomass 6 from the temperature of the thermal collector 5. Said arrangement may decrease the evening out of the temperatures of the thermal collector 5 and the thermomass 6 e.g. due to thermal conduction via the medium between said parts or some other structural parts. In the example of Figure 1, the insulation 11 is arranged only on one surface of the thermomass 6 between the thermomass 6 and the internal part of the enclosure 2, but it may also be arranged, in other embodiments of the space detector, to surround the thermomass 6 from several different directions. In some embodiments of the space detector, the insulation 11 may also be formed as part of the construction of the enclosure 2, whereby no separate insulation part is required.

In the space detector according to the example of Figure 1, the TEG element 7 is arranged for generating electric power to the space detector 1 by means of a temperature difference between the thermal collector 5 and the thermomass 6. In more detail, one of the surfaces of the TEG element 7 is arranged into connection with the thermal collector 5, and another surface of the TEG element 7 is arranged into connection with the thermomass 6 for conveying the temperature difference between these parts to the TEG element 7. Thereby, said connection may be arranged, for example, via a direct contact of said parts and the TEG element or via a heat-conductive medium arranged between said parts and the TEG element. In this case, the TEG element 7 is able to generate electric power for as long as the temperature difference between the thermal collector 5 and the thermomass 6 remains, and the voltage generated by the TEG element 7 is proportional to said temperature difference. In the space detector 1 according to the example of Figure 1, the described contact between the thermomass 6 and the TEG element 7 is realized when a critical temperature value T_{Cr} characteristic of the device is exceeded.

In the construction according to Figure 1, between the TEG element 7 and the thermomass 6 is further arranged a separator 19, which separator 19 is arranged to prevent the contact between the TEG element 7 and the thermomass 6 below the critical temperature value T_{Cr}. In other words, thereby as the space detector 1 is in a temperature lower than said critical temperature value T_{Cr}, the thermomass 6 and the TEG element 7 are in connection with each other by means of the separator 19, and the separator 19 prevents the contact between the surfaces of the TEG element and the thermomass 6 directed towards each other. According to the invention, the separator 19 comprises several thermoplastic pins 20 being in connection with the surfaces of the thermomass 6 and the TEG element 7 directed towards each other, whereby said pins are set at a distance from each other in the area of said surfaces. Therefore, in locations of the surfaces of the thermomass 6 and the TEG element 7 directed towards each other that are not in contact with said thermoplastic pins 20, these surfaces are separated from each other by a layer of air. The construction of the separator 19 may differ in other embodiments of the space detector in a sense that it may comprise a larger number of the thermoplastic pins 20 than shown in Figure 1. The shape and size of the pins may also differ freely from what is shown in Fig.1.

In view of the fact that the space detector 1 comprises the separator 19 formed of thermoplastic pins 20 according to the above description, the critical temperature value T_{Cr} is the melting point of the thermoplastic pin 20. Thereby, when the structure of the space detector 1 reaches said critical temperature value T_{Cr} due to an increase in the temperature caused by e.g. a fire, the melting of the thermoplastic pins 20 results in loss of their load bearing capacity that keeps the thermomass 6 and the TEG element 7 separate from each other. In this context, melting refers to either the thermoplastic pins 20 totally liquefying in a predetermined temperature, or to their sufficient softening as a result of gradual softening which enables the loss of their load bearing capacity as described. In some embodiments of the space detector, the thermoplastic pins 20 may be formed e.g. of thermoplastic wax or a plastic material, and they may be selected of their composition e.g. such that the magnitude of the critical temperature value T_{Cr} is between 50°C to 125°C. The thermoplastic pins 20 are manufactured of a heat-insulating material in order to prevent heat from conveying along them between the thermomass 6 and the TEG element 7.

In the construction of Figure 1, the space detector 1 also comprises a pressing element 18 for pressing the thermomass 6 into contact with the TEG element 7. In other words, said pressing element 18 is arranged to direct a force to the thermomass 6 pressing it towards the TEG element 7, whereby when the space detector 1 is in a temperature below the critical temperature value T_{Cr}, the pressing of the thermomass 4 into contact with the TEG element 7 is prevented by the separator 19. In more detail, the load bearing capacity of the separator 19 consisting of thermoplastic pins 20 prevents thereby the contact from forming. On the other hand, when the temperature of the space detector 1 increases above the critical temperature value T_{Cr} causing the loss of the load bearing capacity of the separator 19, the force caused by the pressing element 18 causes the pressing of the thermomass 4 into contact with the TEG element 7. Since the separator 19 is formed of thermoplastic pins 20, their melting in the critical temperature value T_{Cr} thus enables the pressing of this melted material out from between the thermomass 4 and the TEG element 7 in order to enable the contact between them.

The arrangement according to said description enables the thermomass 4 and the TEG element 7 to remain thermally insulated from each other in temperatures below the critical temperature value T_{Cr}. In more detail, when the separator 19 manufactured of an insulating material forms the only connection between the thermomass 4 and the TEG element 7, heat exchange as low as possible is achieved between them. Thereby, slower heating of the thermomass 4 as a result of thermal energy being conveyed to it from the TEG element 7 is achieved in temperatures lower than the critical temperature value T_{Cr}, thus enabling the formation of a larger temperature difference between the thermomass 4 and the thermal collector 5. This again enables generation of a higher voltage and electric power output of the TEG element 7 at the stage when the contact between the thermomass 4 and the TEG element 7 is formed as the critical temperature value T_{Cr} is exceeded, and thus the greater sensitivity and more accurate reaction of the space detector 1 to an increase in temperature in various conditions. The magnitude of the critical temperature value T_{Cr} being selected e.g. between 50°C to 125°C, said arrangement enables the reaction of the space detector 1 e.g. in situations where the increase in the temperature of the space being monitored caused by a fire or some other incident is particularly slow. When the temperature of the space detector 1 increases above the critical temperature value, its operating principle corresponds to that of an arrangement where there is a direct contact between the thermomass 6 and the TEG element 7.

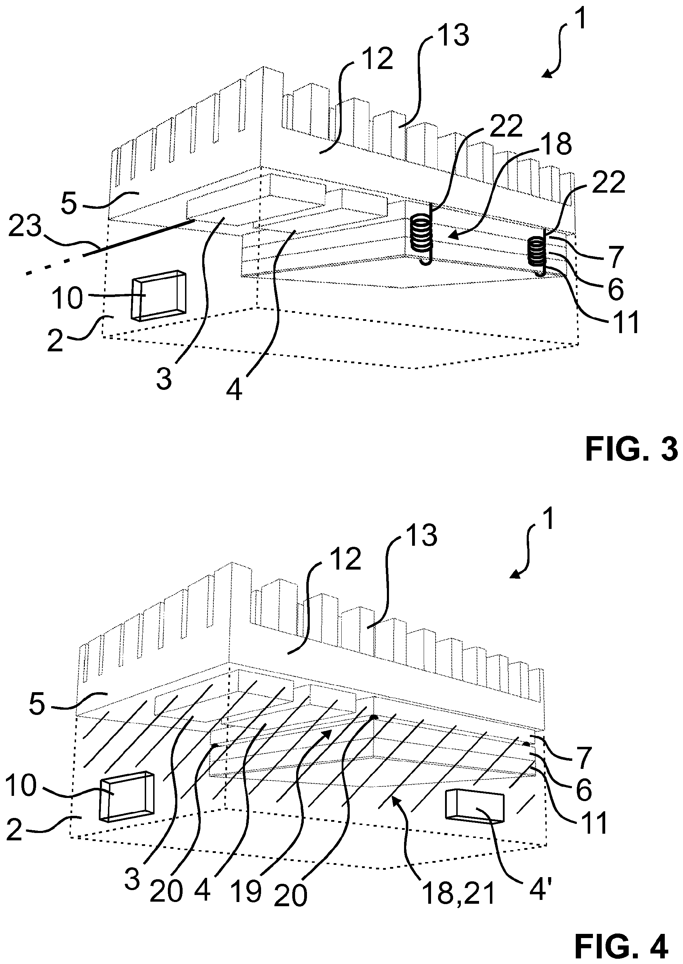

In the example of Figure 1, the pressing element 18 comprises spring elements 22 which are fastened from their one end to the thermomass 4 and thus arranged to produce the force pressing the thermomass 4 towards the TEG element 7. The number of said spring elements 22, the spring elements 22 being in a tensioned state, may differ from said example in other embodiments of the space detector 1, whereby there may be one or more of them. Figure 3 illustrates a second embodiment of the space detector 1 which, in regard to the pressing element 18, corresponds to the example of Figure 1, in a situation where the space detector 1 is in a temperature higher than the critical temperature value T_{Cr}. In the situation shown in Figure 3, the thermomass 4 and the TEG element 7 are thus in contact with each other as a result of the force produced by the spring elements 22 pressing the thermomass 4. The example of Figure 3 also corresponds for most parts to the space detector of the example of Figure 1, and Figure 3 is therefore only discussed here in regard to the differences between said embodiments.

In the example of Figure 4, which illustrates a third embodiment of the space detector 1, the pressing element 18 comprises, instead of the spring elements 22, insulating foam 21 arranged within the enclosure 2. The example of Figure 4 also corresponds for most parts to the space detector of the example of Figure 1, and therefore Figure 4 is only discussed here in regard to the differences between said embodiments.

In order to illustrate the construction of the space detector 1 as clearly as possible, the insulating foam 21 is illustrated by diagonal lines showing its positioning in Figure 4. In more detail, in said example, the insulating foam 21, which may comprise e.g. solid urethane foam, is arranged to fill the interior space of the enclosure 2 of the space detector that is free from other components, whereby the pressure produced by this elastic foam inside the enclosure 2 simultaneously works as the force pressing the thermomass 4 towards the TEG element 7. In this case, the insulating foam 21 simultaneously works as a structure insulating the thermomass 6 and the other internal components of the enclosure 2 of the space detector from the external temperature. In the other embodiments of the space detector 1, the insulating foam 21 may also be arranged to fill the internal space of the enclosure 2 only partially.

In the example of Figure 4, the space detector 1 also comprises a second, additional indicator 4' arranged into cooperation with the indicator 4. In this case, the indication of the alarm may be implemented e.g. as a response to a change detected by the sensor 3 exceeding the limit values set for both of the indicators 4, 4', whereby the indication may be a result of more complex incidents than the direct exceeding of one limit value. Then, the exceeding of a limit value set for one of the indicators 4, 4' may be set to e.g. trigger a preliminary alarm, and the indication of the actual alarm may be set not to occur until the limit values set for both of the indicators 4, 4' are exceeded. Said arrangement thus enables a further improved detection capability of the monitored incident, e.g. a fire, by the space detector 1.

In the examples of Figures 1, 3 and 4, the space detector 1 also comprises an energy storage 10 for storing electric power generated by the TEG element 7. As a result of said arrangement, there is no need to use the electric power generated by the TEG element 7 immediately in the space detector, e.g. for indicating an alarm by the indicator 4, but it is possible to store power e.g. to implement various operations different from each other in terms of their power requirement. Thereby, there may be usable electric power stored in the energy storage 10 as a result of several incidents causing variation in temperature, e.g. as a result of a fire or of the space detector 1 moving between spaces having different temperatures. Sad energy storage 10 may, depending on the embodiment of the space detector, comprise e.g. one or more condensers or battery cells.

In order to indicate a change occurring in the space detected by the sensor 3, e.g. a fire, in a desired way, it is also possible to predetermine to the space detector e.g. a desired value of the charging level of the energy storage 10, after reaching which, the indicator 4 implements a specific measure or a combination of measures. The characteristics of the electric power stored in the energy storage 10, e.g. its voltage, may also be altered by separate components connected to the space detector 1, such as current changers, as required by each operation to be performed. Therefore, the arrangement according to the description may also be used to execute measures that are demanding in terms of the available electric power, the execution of which only by the direct electric current and voltage generated by the TEG element 7 would be impossible.

In some embodiments of the space detector according to the example of Figure 1, the sensor 3 may comprise e.g. an optical sensor, a temperature sensor or a sensor measuring the characteristics, such as electrical conductivity, of the medium surrounding the sensor, such as air. In some embodiments of the space detector, the sensor 3 may also comprise e.g. a sensor measuring the characteristics, e.g. the quality of current or voltage, of the electric power generated by the TEG element 7 or stored in the energy storage 10. In some embodiments of the space detector, the sensor 3 may also comprise a number of separate sensors, whereby the detection of a change occurring in the space being monitored may take place based on the overall data conveyed by these sensors.

The example of Figure 3 illustrates an alternative way to implement the construction of the sensor 3, wherein the sensor 3 comprises a fire sensor cable 23 for detecting an increase in the temperature occurring in the space. Said fire sensor cable 23 thereby extends from the space detector 1 to the space outside of it whereby, in accordance with the operating principle of the fire sensor cable 23, the detection of the increase in temperature occurs as a result of melting of an insulation layer between two wires comprised in it. In more detail, said insulating layer is chosen of its construction such that e.g. a significant increase in temperature indicating a fire causes it to melt, whereby an electric contact is created between said two wires and an internal short circuit is created in the fire detection cable 23. Said arrangement provides the advantage that the detection of the increase in temperature and thus of e.g. a fire may be implemented without components requiring electric power for their operation.

The example of Figure 2 illustrates a diagram of some possible ways of connection of the space detector 1 to various possible parts of a more extensive fire protection system. The connecting ways illustrated in the figure and the parts of the fire protection system are shown by way of examples and are alternative to each other, whereby the system may, depending on each situation, comprise one or more of the shown parts irrespective of the other shown parts. By using the connecting ways shown in Figure 2, it is also possible to connect the space detector to parts of a system other than those shown in the figure, whereby said system may also be intended for something else than fire protection.

As illustrated in the example of Figure 2, in some variations of the space detector 1, the indicator 4 may be arranged to indicate an alarm as a response to a change exceeding a limit value set for the indicator 4 detected by the sensor 3 by triggering an extinguishing arrangement 8. Said extinguishing arrangement may comprise any type of known arrangements for extinguishing a fire, based on e.g. releasing extinguishing water or other material for smothering the fire to the area of fire from inlets arranged in the space being monitored. In some embodiments of the space detector 1, the extinguishing arrangement 8 may also be arranged directly as a part of the space detector 1, whereby the extinguishing arrangement 8 may e.g. be located within the enclosure 2. In all of the mentioned cases, the triggering of the extinguishing arrangement 8 may occur e.g. as an electric triggering.

According to the example of Figure 2, in other variations of the space detector 1, the indicator 4 may be arranged to indicate an alarm by sending an alarm signal via a wired or wireless connection to a predetermined receiver 14. In this case, said receiver 14 may be located freely even at a large distance from the space being monitored, and the same receiver 14 may also be arranged e.g. to receive an alarm signal from several separate space detectors at the same time. When the indicator 4 is arranged to send the alarm signal via a wireless connection, said connection may be arranged to the space detector 1 e.g. via a separate wireless transmitter, such as a radio transmitter.

Further according to the example of Figure 2, in some variations of the space detector 1, the indicator 4 may be arranged to indicate an alarm as a response to a change exceeding a limit value set for the indicator 4 detected by the sensor 3 by activating an incandescent trigger 9. Said incandescent trigger 9 may comprise e.g. an ignition device operated by electric power generated by the TEG element 7, by means of which, it is possible to trigger e.g. an extinguisher 16 operating by a detonating cord 15 according to the example of Figure 2 or some other device arranged in the space being monitored. Said ignition device may consist of e.g. a resistance wire set between two wires set at different voltages, whereby the electric power going through the resistance wire causes heating of the wire to ignite the detonating cord 15. Said arrangement may provide a very controlled increase in temperature in terms of its magnitude and area for igniting the detonating cord 15, whereby the incandescent trigger 9 is also suitable for use in temperature critical targets where e.g. ignition of the detonating cord based on an igniting flame cannot be used. The incandescent trigger 9 may be arranged within the enclosure 2 of the space detector according to the example of Figure 2 or it may be arranged as a part separate from the space detector 1.

In the example of Figure 1, the space detector 1 further comprises a kinetic element 17 for generating electric power for the space detector 1 by means of the movement of the space detector 1. Said kinetic element 17 may comprise e.g. a magnetized piece moving as a result of the movement of the space detector 1, whereby the movement of said magnetized piece may again be changed into electric power by means of conductors. Said arrangement may ensure the availability of electric power required for the operation of the space detector 1 also in use cases where the variation in the temperature of the space being monitored is small but kinetic energy is available. Such uses include e.g. many types of targets to be monitored intended for transport, such as containers in sea transport.

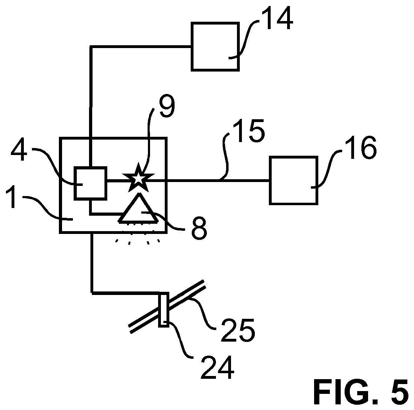

The example of Figure 5 shows a diagram, in a way corresponding to the presentation of Figure 2, of a construction of a space detector in accordance to a fourth embodiment and its connection to a fire protection system. In the construction according to said example, which otherwise corresponds to the space detector of Figures 1-4, the space detector 1 also comprises an inductive energy collector 24 for generating electric power for the space detector 1 by means of electric power from an external electric power network 25. In more detail, said inductive energy collector 24 of the example is arranged into the vicinity of conductors connected to an external electric power network, whereby the electric power passing in these conductors creates induction of a separate electric current in the inductive energy collector 24. This inducted electric power may then be used as a power source for the components of the space detector 1, e.g. as power supplementary to the electric power generated by the TEG element 7. Such an inductive energy collector 24 may be arranged e.g. outside the enclosure 2 and to connect to the space detector 1 via separate conductors. The arrangement according to the description is suitable for use e.g. in targets where the space being monitored by means of the space detector 1 already includes components utilizing an external electric power network. Such targets are e.g. transformer cabinets and switchboards and other spaces where there are live power cables.

It is to be understood that the above description and the related figures are only intended to illustrate the present invention. It will be apparent to a person skilled in the art that the invention may also be varied and modified in other ways without departing from the scope of the invention which is solely defined in the appended claims.

## Claims

1. A space detector (1) comprising:
an enclosure (2),
a sensor (3) for detecting a change occurring in a space,
an indicator (4) which is arranged to indicate an alarm as a response to a change exceeding a limit value set for the indicator (4) detected by the sensor (3),
a thermal collector (5) which is in connection with a space outside the enclosure (2),
a thermomass (6) arranged within the enclosure (2), and
a TEG element (7) arranged between the thermal collector (5) and the thermomass (6) for generating electric power to the space detector (1) by means of a temperature difference between the thermal collector (5) and the thermomass (6),
a pressing element (18) for pressing the thermomass (6) into contact with the TEG element (7), **characterized in that** the space detector (1) additionally comprises:
a separator (19) formed of thermoplastic pins manufactured of a heat-insulating material arranged between the TEG element (7) and the thermomass (6), which separator (19) is arranged to prevent the contact between the TEG element (7) and the thermomass (6) below a critical temperature value (T_{Cr}).

2. The space detector (1) according to claim 1, **characterized in that** the critical temperature value (T_{Cr}) is the melting point of the thermoplastic pin (20).

3. The space detector (1) according to claim 1 or 2, **characterized in that** the critical temperature value (T_{Cr}) is between 50 °C to 125 °C.

4. The space detector (1) according to any one of claims 1-3, **characterized in that** the pressing element (18) comprises insulating foam (21) arranged within the enclosure (2).

5. The space detector (1) according to any one of claims 1-3, **characterized in that** the pressing element (18) comprises at least one spring element (22).

6. The space detector (1) according to any one of claims 1-5, **characterized in that** the sensor (3) comprises a fire sensor cable (23) for detecting an increase in temperature occurring in the space.

7. The space detector (1) according to any one of claims 1-6, **characterized in that** the indicator (4) is arranged to indicate an alarm as a response to a change exceeding a limit value set for the indicator (4) detected by the sensor (3) by triggering an extinguishing arrangement (8).

8. The space detector (1) according to claim 7, **characterized in that** the extinguishing arrangement (8) is arranged as a part of the space detector (1).

9. The space detector (1) according to any one of claims 1-6, **characterized in that** the indicator (4) is arranged to indicate an alarm as a response to a change exceeding a limit value set for the indicator (4) detected by the sensor (3) by sending an alarm signal via a wired or wireless connection to a predetermined receiver (14).

10. The space detector (1) according to any one of claims 1-6, **characterized in that** the indicator (4) is arranged to indicate an alarm as a response to a change exceeding a limit value set for the indicator (4) detected by the sensor (3) by activating an incandescent trigger (9).

11. The space detector (1) according to any one of claims 1-10, **characterized in that** the space detector (1) further comprises an energy storage (10) for storing electric power generated by the TEG element (7).

12. The space detector (1) according to any one of claims 1-11, **characterized in that** on the surface of the thermomass (6) is arranged an insulation (11) between the thermomass (6) and the interior of the enclosure (2) for insulating the thermomass (6) from the temperature of the thermal collector (5).

13. The space detector (1) according to any one of claims 1-12, **characterized in that** the space detector (1) further comprises a kinetic element (17) for generating electric power for the space detector (1) by means of movement of the space detector (1).

14. The space detector (1) according to any one of claims 1-13, **characterized in that** the space detector (1) further comprises an inductive energy collector (24) for generating electric power for the space detector (1) by means of electric power from an external electric power network (25).

## Patentansprüche

1. Raumdetektor (1), umfassend:
ein Gehäuse (2),
einen Sensor (3) zum Erfassen einer in einem Raum auftretenden Änderung,
einen Indikator (4), der dazu angeordnet ist, einen Alarm, als Reaktion auf eine durch den Sensor (3) erfasste Änderung, anzuzeigen, die einen für den Indikator (4) festgelegten Grenzwert überschreitet,
einen Wärmekollektor (5), der mit einem Raum außerhalb des Gehäuses (2) in Verbindung steht,
eine thermische Masse (6), die innerhalb des Gehäuses (2) angeordnet ist, und
ein TEG-Element (7), das zwischen dem Wärmekollektor (5) und der thermischen Masse (6) angeordnet ist, zur Erzeugung elektrischer Energie für den Raumdetektor (1) mittels eines Temperaturunterschieds zwischen dem Wärmekollektor (5) und der thermischen Masse (6),
ein Druckelement (18) zum Drücken der thermischen Masse (6) in Kontakt mit dem TEG-Element (7), **dadurch gekennzeichnet, dass** der Raumdetektor (1) zusätzlich umfasst:
ein Trennelement (19), gebildet aus thermoplastischen Stiften die aus wärmeisolierendem Material hergestellt sind, angeordnet zwischen dem TEG-Element (7) und der thermischen Masse (6), wobei das Trennelement (19) dazu angeordnet ist, den Kontakt zwischen dem TEG-Element (7) und der thermischen Masse (6) unterhalb eines kritischen Temperaturwerts (T_{Cr}) zu verhindern.

2. Raumdetektor (1) nach Anspruch 1, **dadurch gekennzeichnet, dass** der kritische Temperaturwert (T_{Cr}) der Schmelzpunkt des thermoplastischen Stifts (20) ist.

3. Raumdetektor (1) nach Anspruch 1 oder 2, **dadurch gekennzeichnet, dass** der kritische Temperaturwert (T_{Cr}) zwischen 50 °C und 125 °C liegt.

4. Raumdetektor (1) nach einem der Ansprüche 1-3, **dadurch gekennzeichnet, dass** das Druckelement (18) Isolierschaum (21) umfasst, der innerhalb des Gehäuses (2) angeordnet ist.

5. Raumdetektor (1) nach einem der Ansprüche 1-3, **dadurch gekennzeichnet, dass** das Druckelement (18) mindestens ein Federelement (22) umfasst.

6. Raumdetektor (1) nach einem der Ansprüche 1-5, **dadurch gekennzeichnet, dass** der Sensor (3) ein Feuersensorkabel (23) zum Erfassen einer im Raum auftretenden Erhöhung der Temperatur umfasst.

7. Raumdetektor (1) nach einem der Ansprüche 1-6, **dadurch gekennzeichnet, dass** der Indikator (4) dazu angeordnet ist, einen Alarm als Reaktion auf eine Änderung anzuzeigen, die einen für den Indikator (4) festgelegten Grenzwert überschreitet und durch den Sensor (3) erfasst wird, durch das Auslösen einer Löschanordnung (8).

8. Raumdetektor (1) nach Anspruch 7, **dadurch gekennzeichnet, dass** die Löschanordnung (8) als ein Teil des Raumdetektors (1) angeordnet ist.

9. Raumdetektor (1) nach einem der Ansprüche 1-6, **dadurch gekennzeichnet, dass** der Indikator (4) dazu angeordnet ist, einen Alarm als Reaktion auf eine Änderung anzuzeigen, die einen für den Indikator (4) festgelegten Grenzwert überschreitet und durch den Sensor (3) erfasst wird, durch das Senden eines Alarmsignals über eine drahtgebundene oder drahtlose Verbindung an einen vorbestimmten Empfänger (14).

10. Raumdetektor (1) nach einem der Ansprüche 1-6, **dadurch gekennzeichnet, dass** der Indikator (4) dazu angeordnet ist, einen Alarm als Reaktion auf eine Änderung anzuzeigen, die einen für den Indikator (4) festgelegten Grenzwert überschreitet und durch den Sensor (3) erfasst wird, durch das Aktivieren eines Glühzünders (9).

11. Raumdetektor (1) nach einem der Ansprüche 1-10, **dadurch gekennzeichnet, dass** der Raumdetektor (1) weiter einen Energiespeicher (10) zum Speichern der durch das TEG-Element (7) erzeugten elektrischen Energie umfasst.

12. Raumdetektor (1) nach einem der Ansprüche 1-11, **dadurch gekennzeichnet, dass** auf der Oberfläche der thermischen Masse (6) eine Isolierung (11) zwischen der thermischen Masse (6) und dem Inneren des Gehäuses (2) zum Isolieren der thermischen Masse (6) von der Temperatur des Wärmekollektors (5) angeordnet ist.

13. Raumdetektor (1) nach einem der Ansprüche 1-12, **dadurch gekennzeichnet, dass** der Raumdetektor (1) weiter ein kinetisches Element (17) zur Erzeugung elektrischer Energie für den Raumdetektor (1) mittels einer Bewegung des Raumdetektors (1) umfasst.

14. Raumdetektor (1) nach einem der Ansprüche 1-13, **dadurch gekennzeichnet, dass** der Raumdetektor (1) weiter einen induktiven Energiesammler (24) zur Erzeugung elektrischer Energie für den Raumdetektor (1) mittels elektrischer Energie aus einem externen elektrischen Versorgungsnetz (25) umfasst.

## Revendications

1. Détecteur d'espace (1) comprenant :
une enceinte (2),
un capteur (3) destiné à détecter un changement se produisant dans un espace,
un indicateur (4) qui est agencé pour indiquer une alarme en réponse à un changement dépassant une valeur limite définie pour l'indicateur (4) détecté par le capteur (3),
un collecteur thermique (5) qui est en connexion avec un espace situé à l'extérieur de l'enceinte (2),
une masse thermique (6) agencée à l'intérieur de l'enceinte (2) et
un élément TEG (7) agencé entre le collecteur thermique (5) et la masse thermique (6) pour générer de l'énergie électrique pour le détecteur d'espace (1) au moyen d'une différence de température entre le collecteur thermique (5) et la masse thermique (6),
un élément de pression (18) pour presser la masse thermique (6) en contact avec l'élément TEG (7), **caractérisé en ce que** le détecteur d'espace (1) comprend en outre :
un séparateur (19) formé de broches thermoplastiques fabriquées d'un matériau isolant thermique, agencé entre l'élément TEG (7) et la masse thermique (6), lequel séparateur (19) est agencé pour empêcher le contact entre l'élément TEG (7) et la masse thermique (6) en dessous d'une valeur de température critique (T_{Cr}).

2. Détecteur d'espace (1) selon la revendication 1, **caractérisé en ce que** la valeur de température critique (T_{Cr}) est le point de fusion de la broche thermoplastique (20).

3. Détecteur d'espace (1) selon la revendication 1 ou la revendication 2, **caractérisé en ce que** la valeur de température critique (T_{Cr}) est comprise entre 50 °C et 125 °C.

4. Détecteur d'espace (1) selon l'une quelconque des revendications 1 à 3, **caractérisé en ce que** l'élément de pression (18) comprend de la mousse isolante (21) agencée à l'intérieur de l'enceinte (2).

5. Détecteur d'espace (1) selon l'une quelconque des revendications 1 à 3, **caractérisé en ce que** l'élément de pression (18) comprend au moins un élément ressort (22).

6. Détecteur d'espace (1) selon l'une quelconque des revendications 1 à 5, **caractérisé en ce que** le capteur (3) comprend un câble capteur d'incendie (23) pour détecter une augmentation de température se produisant dans l'espace.

7. Détecteur d'espace (1) selon l'une quelconque des revendications 1 à 6, **caractérisé en ce que** l'indicateur (4) est agencé pour indiquer une alarme en réponse à un changement dépassant une valeur limite définie pour l'indicateur (4) détecté par le capteur (3) en déclenchant un dispositif d'extinction (8).

8. Détecteur d'espace (1) selon la revendication 7, **caractérisé en ce que** le dispositif d'extinction (8) est agencé en tant que partie du détecteur d'espace (1).

9. Détecteur d'espace (1) selon l'une quelconque des revendications 1 à 6, **caractérisé en ce que** l'indicateur (4) est agencé pour indiquer une alarme en réponse à un changement dépassant une valeur limite définie pour l'indicateur (4) détecté par le capteur (3) en envoyant un signal d'alarme par le biais d'une liaison filaire ou sans fil à un récepteur prédéterminé (14).

10. Détecteur d'espace (1) selon l'une quelconque des revendications 1 à 6, **caractérisé en ce que** l'indicateur (4) est agencé pour indiquer une alarme en réponse à un changement dépassant une valeur limite définie pour l'indicateur (4) détecté par le capteur (3) en activant un déclencheur incandescent (9).

11. Détecteur d'espace (1) selon l'une quelconque des revendications 1 à 10, **caractérisé en ce que** le détecteur d'espace (1) comprend en outre un moyen de stockage d'énergie (10) pour stocker de l'énergie électrique générée par l'élément TEG (7).

12. Détecteur d'espace (1) selon l'une quelconque des revendications 1 à 11, **caractérisé en ce que**, sur la surface de la masse thermique (6), est agencée une isolation (11) entre la masse thermique (6) et l'intérieur de l'enceinte (2) pour isoler la masse thermique (6) de la température du collecteur thermique (5).

13. Détecteur d'espace (1) selon l'une quelconque des revendications 1 à 12, **caractérisé en ce que** le détecteur d'espace (1) comprend en outre un élément cinétique (17) pour générer de l'énergie électrique pour le détecteur d'espace (1) au moyen du mouvement du détecteur d'espace (1).

14. Détecteur d'espace (1) selon l'une quelconque des revendications 1 à 13, **caractérisé en ce que** le détecteur d'espace (1) comprend en outre un collecteur d'énergie par induction (24) pour générer de l'énergie électrique pour le détecteur d'espace (1) au moyen de l'énergie électrique provenant d'un réseau d'alimentation électrique externe (25).
